# EUROPÄISCHE PATENTANMELDUNG

(11) **EP 1 748 381 A1**
(43) Veröffentlichungstag der Anmeldung: **31.01.2007**
(21) Anmeldenummer: 06015710.4
(22) Anmeldetag: 27.07.2006
(51) Int. Cl.: G06K 19/077, H05K 1/18

(54) **Anlage zur Fertigung elektronischer Baugruppen oder Leiterplatten welche RFID-Chips umfassen**

(30) Priorität: 29.07.2005 DE 202005011948 U
(71) Anmelder: ILFA Industrieelektronik und Leiterplattenfertigung aller Art GmbH, 30559 Hannover (DE)
(72) Erfinder: Süllau, Walter, 38100 Braunschweig (DE); Jähnert, Manfred, 31515 Wunstorf (DE)
(74) Vertreter: Patentanwälte Thömen & Körner

(57) **Zusammenfassung**

Die Anlage umfasst eine Vorrichtung zur Einbringung von Niveaubohrungen oder Durchgangsbohrungen oder Niveaufräsungen oder Durchgangsfräsungen in einen Leiterplatternutzen, eine Bestückungsvorrichtung zur Bestückung der Niveaubohrungen oder Durchgangsbohrungen oder Niveaufräsungen oder Durchgangsfräsungen mit RFID-Chips oder mit Temperatursensoren ausgestatteten oder verbundenen RFID-Chips. Ferner umfasst die Anlage eine Verschlussvorrichtung für die mit RFID-Chips oder mit Temperatursensoren ausgestatteten oder verbundenen RFID-Chips bestückten Niveaubohrungen oder Durchgangsbohrungen oder Niveaufräsungen oder Durchgangsfräsungen.

## Beschreibung

Die Erfindung betrifft eine Anlage zur Fertigung elektronischer Baugruppen und/oder Leiterplatten nach dem Oberbegriff des Anspruchs 1 sowie eine Anlage zur Fertigung elektronischer Baugruppen und/oder Leiterplatten, welche RFID-Chips oder mit Temperatursensoren ausgestattete oder verbundene RFID-Chips umfassen, nach dem Oberbegriff des Anspruchs 10.

Elektronische Baugruppen und/oder Leiterplatten mit integrierten RFID-Chips sind u. a. aus der US 2002/0125997 A1, der FR 2 850 832 A1, der DE 100 39 997 A1, der DE 100 56 112 A1 oder der DE 92 09 575 U1 bekannt. Die in den RFID-Chips gespeicherten Daten dienen der Identifizierung und Rückverfolgbarkeit der elektronischen Baugruppen und/oder Leiterplatten bei und nach der Produktion sowie bei Reklamationen.

Die Integration von RFID-Chips in elektronischen Baugruppen und/oder Leiterplatten erfordert Arbeitsschritte, die sich weder in einen konventionellen Herstellüngsprozess für elektronische Baugruppen und/oder Leiterplatten, noch einen konventionellen Bestückungs- und Lötprozess einbinden lassen und daher auf bestehenden Anlagen nicht ausführen lassen. Vielmehr müssten die elektronischen Baugruppen und/oder Leiterplatten aus dem üblicherweise kontinuierlichen Fertigungsprozess ausgeschleust und gesondert bearbeitet werden.

Der Erfindung liegt die Aufgabe zugrunde, eine Anlage zur Fertigung elektronischer Baugruppen und/oder Leiterplatten dahingehend zu ergänzen, dass die Integration von RFID-Chips im laufenden Fertigungsprozess der elektronischen Baugruppen und/oder Leiterplatten ermöglicht wird.

Diese Aufgabe wird bei einer Anlage nach dem Oberbegriff des Anspruchs 1 durch Merkmale dieses Anspruchs gelöst.

Ferner liegt der Erfindung die Aufgabe zugrunde, eine Anlage zur Fertigung elektronischer Baugruppen und/oder Leiterplatten, welche RFID-Chips oder mit Temperatursensoren ausgestattete oder verbundene RFID-Chips umfassen, dahingehend zu ergänzen, dass auch die Endfertigung verbessert und vereinfacht wird.

Diese Aufgabe wird bei einer Anlage nach dem Oberbegriff des Anspruchs 10 durch Merkmale jenes Anspruchs gelöst.

Weiterbildungen und vorteilhafte Ausgestaltungen ergeben sich aus den jeweiligen Unteransprüchen.

Durch eine Vorrichtung zur Einbringung von Niveaubohrungen oder Durchgangsbohrungen oder Niveaufräsungen oder Durchgangsfräsungen in einen Leiterplatternutzen kann eine elektronische Baugruppe und/oder Leiterplatte zuerst konventionell ohne Berücksichtung einer Ausnehmung für den RFID-Chip gefertigt werden. Diese Ausnehmung wird vielmehr nachträglich an einer freien Stelle des Leiterplattennutzens gebohrt/gefräst. Durch die Einbeziehung der Vorrichtung zur Einbringung von Niveaubohrungen oder Durchgangsbohrungen oder Niveaufräsungen oder Durchgangsfräsungen in die Anlage entfällt ein Ausschleusen der elektronischen Baugruppe und/oder Leiterplatte zur Schaffung der Ausnehmung für den RFID-Chip. Die Niveaubohrung oder Durchgangsbohrung oder Niveaufräsung oder Durchgangsfräsung kann innerhalb des Fertigungsprozesses der elektronischen Baugruppe und/oder Leiterplatte gesetzt werden.

Durch die Einbeziehung einer Bestückungsvorrichtung zur Bestückung der Niveaubohrungen oder Durchgangsbohrungen oder Niveaufräsungen oder Durchgangsfräsungen mit RFID-Chips oder mit Temperatursensoren ausgestatteten oder verbundenen RFID-Chips ebenfalls in die Anlage erfolgt die Bestückung unmittelbar nach Fertigstellung der Niveaubohrung oder Durchgangsbohrung oder Niveaufräsung oder Durchgangsfräsung.

Durch die zusätzliche Einbeziehung einer Verschlussvorrichtung für die mit RFID-Chips oder mit Temperatursensoren ausgestatteten oder verbundenen RFID-Chips bestückten Niveaubohrungen oder Durchgangsbohrungen oder Niveaufräsungen oder Durchgangsfräsungen in die Anlage erfolgt auch der Verschluss der bestückten Bohrung unmittelbar nach dem Bestückungsvorgang.

Die soweit gefertigte elektronische Baugruppe und/oder Leiterplatte bildet mit dem RFID-Chip eine Einheit die ohne Zerstörung der elektronischen Baugruppe und/oder Leiterplatte und/oder des RFID-Chips nicht mehr getrennt werden kann.

Gemäß einer ersten Ausführung kann die Verschlussvorrichtung eine Abgabevorrichtung für flüssige oder pastöse Vergussmasse zur Einbringung in die Niveaubohrungen oder Durchgangsbohrungen oder Niveaufräsungen oder Durchgangsfräsungen sein.

Dadurch lässt sich der RFID-Chip schnell und unzugänglich fixieren und Hohlräume zwischen dem RFID-Chip und der Wand der Niveaubohrung oder Durchgangsbohrung oder Niveaufräsung oder Durchgangsfräsung sowie der Oberfläche der Leiterplatte verfüllen.

Die Verschlussvorrichtung kann zusätzlich eine Härtevorrichtung für die flüssige oder pastöse Vergussmasse umfassen.

Die Aushärtung der flüssigen oder pastösen Vergussmasse lässt sich so beschleunigen und die Fertigungszeit verkürzen.

Die Härtevorrichtung kann eine UV-Lichtquelle zur Bestrahlung UV-härtbarer Vergussmasse sein.

Es kann Vergussmasse verwendet werden, die in normaler Umgebung lange viskos und verarbeitbar ist, aber nach Einbringung in die Niveaubohrung oder Durchgangsbohrung oder Niveaufräsung oder Durchgangsfräsung unter UV-Licht sehr schnell aushärtet.

Gemäß einer zweiten Ausführung kann die Verschlussvorrichtung eine Laminiervorrichtung zur Aufbringung von Prepregs sein.

Hierbei handelt es sich um eine Vorrichtung, die ohnehin Bestandteil einer Fertigungsanlage für mehrschichtige elektronische Baugruppen und/oder Leiterplatten ist. Diese Vorrichtung kann somit für den Verschluss der Niveaubohrung oder Durchgangsbohrung oder Niveaufräsung oder Durchgangsfräsung mit genutzt werden.

Vorzugsweise umfasst die Anlage zusätzlich eine Schreib-/Lesevorrichtung zum kontaktlosen Beschreiben und/oder Lesen von Daten der RFID-Chips oder der mit Temperatursensoren ausgestatteten oder verbundenen RFID-Chips.

Dadurch sind unmittelbar nach Fertigstellung der elektronischen Baugruppe und/oder Leiterplatte mit dem RFID-Chip eine Funktionsprüfung des RFID-Chips und ein Beschreiben mit Identifikationsdaten, Auftragsdaten und gegebenenfalls Prozessdaten und Logistikdaten für eine Weiterverarbeitung möglich.

Die Vorrichtung zur Einbringung von Niveaubohrungen oder Durchgangsbohrungen oder Niveaufräsungen oder Durchgangsfräsungen, die Bestückungsvorrichtung zur Bestückung der Niveaubohrungen oder Durchgangsbohrungen oder Niveaufräsungen oder Durchgangsfräsungen mit RFID-Chips oder mit Temperatursensoren ausgestatteten oder verbundenen RFID-Chips und die Verschlussvorrichtung sind vorzugsweise nacheinander an einem Inline-Fertigungsband oder einer Inline-Fertigungsstraße der Anlage angeordnet.

Zusätzlich kann auch die Schreib-/Lesevorrichtung nach der Bestückungsvorrichtung oder nach der Verschlussvorrichtung an dem Inline-Fertigungsband oder der Inline-Fertigungsstraße angeordnet sein.

Die Fertigung der elektronischen Baugruppen und/oder Leiterplatten mit den RFID-Chips und gegebenenfalls die Funktionsprüfung und das Beschreiben wird so in einem kontinuierlichen Prozess vorgenommen, wobei sich die Fertigungsschritte für das Einbringen der RFID-Chips unmittelbar an die Fertigungsschritte der elektronischen Baugruppe und/oder Leiterplatte selbst anfügen und dem gleichen Arbeitstakt unterliegen.

Da der Arbeitstakt durch die zeitaufwendigere Fertigung der elektronischen Baugruppen und/oder Leiterplatten selbst bestimmt wird, führen die zusätzlichen Arbeitsschritte bei einer Serienfertigung dann zu keiner wesentlichen Verlängerung der Fertigungszeit einer Serie.

Weiterhin kann die Vorrichtung zur Einbringung von Niveaubohrungen oder Durchgangsbohrungen oder Niveaufräsungen oder Durchgangsfräsungen einen Bohrkopf und die Bestückungsvorrichtung einen Bestückungskopf umfassen, die mittels frei programmierbarer Positionierungsvorrichtungen über den Leiterplattennutzen positionierbar sind.

Bei dieser Ausführung lassen sich Niveaubohrungen oder Durchgangsbohrungen oder Niveaufräsungen oder Durchgangsfräsungen und Bestückungen von Leiterplattennutzen unter nahezu beliebigen Stellen der Leiterplattennutzen und auch mehrfach ausführen, ohne dass eine Umrüstung der Anlage nötig ist.

Die Anlage zur Fertigung elektronischer Baugruppen und/oder Leiterplatten, welche RFID-Chips oder mit Temperatursensoren ausgestattete oder verbundene RFID-Chips umfassen, kann sich unmittelbar an die Anlage zur Einbringung der RFID-Chips anschließen oder auch räumlich getrennt arbeiten.

Die RFID-Chips enthalten Logistikdaten und/oder prozessspezifische Daten und die Anlage umfasst eine Schreib-/Lesevorrichtung, mittels der die Logistikdaten und/oder prozessspezifischen Daten lesbar sind. Die Schreib-/Lesevorrichtung ist mit einer Prozesssteuervorrichtung verbunden, mittels der Fertigungsparameter und/oder Fertigungsschritte und/oder Logistikschritte der Anlage steuerbar sind.

Hierdurch wird eine Steuerung der Anlage durch elektronische Baugruppen und/oder Leiterplatten mit den RFID-Chips selbst vorgenommen. Eine individuelle Steuerung ist so möglich. Es können daher auch elektronische Baugruppen und/oder Leiterplatten, die unterschiedliche Bestückungs- und Lötvorgänge erfordern, in gemischter Reihenfolge verarbeitet werden. Synchronisationsfehler zwischen Prozessdaten, die einerseits von der Anlage verwaltet werden und andererseits für eine individuelle elektronische Baugruppe und/oder Leiterplatte benötigt werden, lassen sich daher vermeiden.

Weiterhin können während der Fertigung auftretende Temperaturen, denen die elektronische Baugruppe und/oder Leiterplatte ausgesetzt ist, mittels des Temperatursensors erfassbar und im RFID-Chips speicherbar sein. Die Temperaturen oder auch ein Temperaturverlauf kann anschließend mittels der Schreib-/Lesevorrichtung nach der Fertigung ausgelesen werden.

Dies ermöglicht eine laufende Qualitätskontrolle während der Fertigung hinsichtlich ausreichender Löttemperatur für einwandfreie Lötverbindungen oder Schädigung von Bauteilen durch unzulässig hohe Temperatur.

Vorzugsweise sind mittels der Schreib-/Lesevorrichtung Fertigungs- und/oder Auftragsdaten während oder nach der Fertigung in die RFID-Chips schreibbar.

Durch Einbeziehung der Schreib-/Lesevorrichtung in die Anlage besteht eine unmittelbare logische und räumliche Verknüpfung zwischen den Fertigungs- und/oder Auftragsdaten und den elektronischen Baugruppen und/oder Leiterplatten. Ein vorheriges Lesen der Identifikationsdaten zur Überprüfung der richtigen Zuordnung kann daher entfallen. Ebenso sind Verwechslungen ausgeschlossen, wie sie bei einem nachträglichen Beschreiben auftreten könnten.

Ergänzend kann die Schreiblesevorrichtung über eine Schnittstelle oder über eine Schnittstelle und ein Netzwerk mit einer Datenverarbeitungsanlage verbunden sein.

Dadurch ist ein Datenaustausch zwischen allen Prozessbeteiligten und Anwendern möglich.

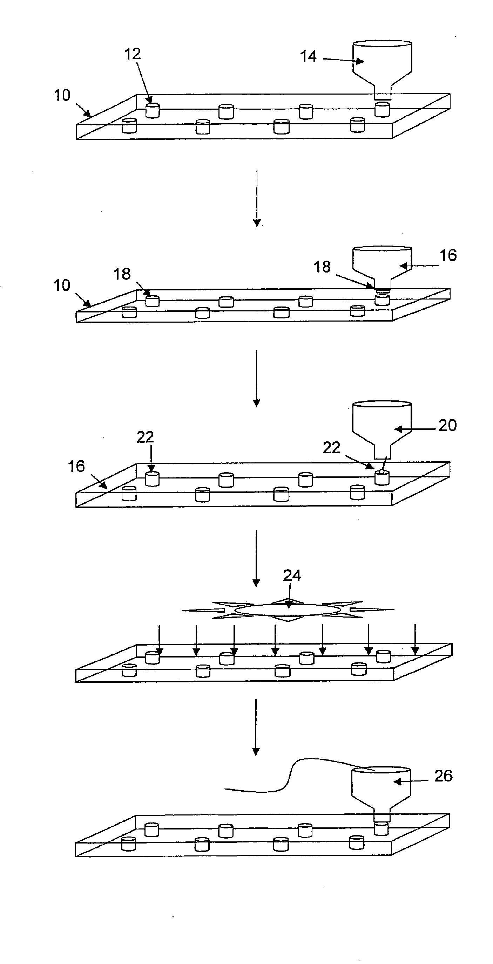

Nachfolgend wird die Erfindung anhand eines Ausführungsbeispiels erläutert, das in der Zeichnung dargestellt ist.

Die Zeichnung zeigt einen Teil einer Anlage zur Fertigung elektronischer Baugruppen und/oder Leiterplatten.

Auf einem Inline-Fertigungsband gelangen vorgefertigte elektronische Baugruppen und/oder Leiterplatten, die aus mehreren Schichten aus Prepregs und Leiterschichten laminiert sind, als Leiterplatternutzen zu einer Vorrichtung zur Einbringung von Niveaubohrungen oder Durchgangsbohrungen oder Niveaufräsungen oder Durchgangsfräsungen.

Die Vorrichtung umfasst einen Bohrkopf 14, der über eine frei programmierbarer Positionierungsvorrichtung an beliebiger Stelle über dem Leiterplatternutzen 10 positionierbar ist. An geeigneten Stellen des Leiterplatternutzens 10 werden Niveaubohrungen oder Durchgangsbohrungen oder Niveaufräsungen oder Durchgangsfräsungen 12 in diesen eingebracht, deren Durchmesser und Tiefe so bemessen ist, dass RFID-Chips vollständig in die Niveaubohrungen oder Durchgangsbohrungen oder Niveaufräsungen oder Durchgangsfräsungen ohne Überstand hineinpassen. Übliche Chipabmessungen betragen 6 mm * 6 mm * 300 µm.

Daran schließt sich eine Bestückungsvorrichtung mit einem Bestückungskopf 16 zur Bestückung der Niveaubohrungen oder Durchgangsbohrungen oder Niveaufräsungen oder Durchgangsfräsungen mit RFID-Chips 18 oder mit Temperatursensoren ausgestatteten oder verbundenen RFID-Chips an. Der Bestückungskopf 16 entnimmt aus einem Vorratsbehälter RFID-Chips oder mit Temperatursensoren ausgestattete oder verbundene RFID-Chips und setzt diese in die Niveaubohrungen oder Durchgangsbohrungen oder Niveaufräsungen oder Durchgangsfräsungen ein.

Der Bestückungsvorrichtung folgt eine Verschlussvorrichtung für die mit RFID-Chips oder mit Temperatursensoren ausgestatteten oder verbundenen RFID-Chips bestückten Niveaubohrungen oder Durchgangsbohrungen oder Niveaufräsungen oder Durchgangsfräsungen. Diese Bestückungsvorrichtung umfasst eine Abgabevorrichtung 20 für flüssige oder pastöse Vergussmasse 22, welche Zwischenräume zwischen dem Chip und der Wandung der Niveaubohrung oder Durchgangsbohrung oder Niveaufräsung oder Durchgangsfräsung sowie zwischen dem Chip und der Oberfläche der elektronischen Baugruppe und/oder Leiterplatte ausfüllen und bündig mit der Oberfläche der elektronischen Baugruppe und/oder Leiterplatte abschließen. Als flüssige oder pastöse Vergussmasse wird eine UV-härtbarer Vergussmasse eingesetzt.

Zur schnellen Härtung schließt sich eine Härtevorrichtung aus einer UV-Lichtquelle 24 zur Bestrahlung UV-härtbarer Vergussmasse an. Nach Passieren der Härtevorrichtung ist die Montage der RFID-Chips abgeschlossen.

Im Anschluss an die Härtevorrichtung ist eine Schreib-/Lesevorrichtung angeordnet. Hiermit wird durch einen Schreib-/Lesekopf 26 ein Schreib-Lesevorgang für eine Funktionsprüfung der RFID-Chips und ein Beschreiben mit Identifikationsdaten und Auftragsdaten vorgenommen. Ergänzend können auch Prozessdaten und Logistikdaten für eine Weiterverarbeitung eingeschrieben und gespeichert werden.

Für eine Weiterverarbeitung, insbesondere für Bestückungs- und Lötvorgänge kann eine weitere Schreib-/Lesevorrichtung mit einer Prozesssteuervorrichtung verbunden sein. Mittels der gelesenen Prozessdaten und Logistikdaten lassen sich Fertigungsparameter und/oder Fertigungsschritte und/oder Logistikschritte der Anlage steuern.

Hierdurch wird eine Steuerung der Anlage durch elektronische Baugruppen und/oder Leiterplatten mit den RFID-Chips selbst vorgenommen. Eine individuelle Steuerung ist so möglich. Es können daher auch elektronische Baugruppen und/oder Leiterplatten, die unterschiedliche Bestückungs- und Lötvorgänge erfordern, in gemischter Reihenfolge verarbeitet werden. Synchronisationsfehler zwischen Prozessdaten, die einerseits von der Anlage verwaltet werden und andererseits für eine individuelle elektronischen Baugruppe und/oder Leiterplatte benötigt werden, lassen sich daher vermeiden.

## Patentansprüche

1. Anlage zur Fertigung elektronischer Baugruppen und/oder Leiterplatten, **dadurch gekennzeichnet, dass** die Anlage eine Vorrichtung zur Einbringung von Niveaubohrungen oder Durchgangsbohrungen oder Niveaufräsungen oder Durchgangsfräsungen in einen Leiterplatternutzen, eine Bestückungsvorrichtung zur Bestückung der Niveaubohrungen oder Durchgangsbohrungen oder Niveaufräsungen oder Durchgangsfräsungen mit RFID-Chips oder mit Temperatursensoren ausgestatteten oder verbundenen RFID-Chips und eine Verschlussvorrichtung für die mit RFID-Chips oder mit Temperatursensoren ausgestatteten oder verbundenen RFID-Chips bestückten Niveaubohrungen oder Durchgangsbohrungen oder Niveaufräsungen oder Durchgangsfräsungen umfasst.

2. Anlage nach Anspruch 1, **dadurch gekennzeichnet, dass** die Verschlussvorrichtung eine Abgabevorrichtung für flüssige oder pastöse Vergussmasse zur Einbringung in die Niveaubohrungen oder Durchgangsbohrungen oder Niveaufräsungen oder Durchgangsfräsungen ist.

3. Anlage nach Anspruch 2, **dadurch gekennzeichnet, dass** die Verschlussvorrichtung zusätzlich eine Härtevorrichtung für die flüssige oder pastöse Vergussmasse umfasst.

4. Anlage nach Anspruch 3, **dadurch gekennzeichnet, dass** die Härtevorrichtung eine UV-Lichtquelle zur Bestrahlung UV-härtbarer Vergussmasse ist.

5. Anlage nach Anspruch 1, **dadurch gekennzeichnet, dass** die Verschlussvorrichtung eine Laminiervorrichtung zur Aufbringung von Prepregs ist.

6. Anlage nach einem der Ansprüche 1 bis 5, **dadurch gekennzeichnet, dass** die Anlage zusätzlich eine Schreib-/Lesevorrichtung zum kontaktlosen Beschreiben und/oder Lesen von Daten der RFID-Chips oder der mit Temperatursensoren ausgestatteten oder verbundenen RFID-Chips umfasst.

7. Anlage nach einem der Ansprüche 1 bis 6, **dadurch gekennzeichnet, dass** die Vorrichtung zur Einbringung von Niveaubohrungen oder Durchgangsbohrungen oder Niveaufräsungen oder Durchgangsfräsungen, die Bestückungsvorrichtung zur Bestückung der Niveaubohrungen oder Durchgangsbohrungen oder Niveaufräsungen oder Durchgangsfräsungen mit RFID-Chips oder mit Temperatursensoren ausgestatteten oder verbundenen RFID-Chips und die Verschlussvorrichtung nacheinander an einem Inline-Fertigungsband oder einer Inline-Fertigungsstraße angeordnet sind.

8. Anlage nach Anspruch 7, **dadurch gekennzeichnet, dass** die Schreib-/Lesevorrichtung nach der Bestückungsvorrichtung oder nach der Verschlussvorrichtung an dem Inline-Fertigungsband oder der Inline-Fertigungsstraße angeordnet ist.

9. Anlage nach einem der Ansprüche 1 bis 8, **dadurch gekennzeichnet, dass** die Vorrichtung zur Einbringung von Niveaubohrungen oder Durchgangsbohrungen oder Niveaufräsungen oder Durchgangsfräsungen einen Bohrkopf und die Bestückungsvorrichtung einen Bestückungskopf umfassen, die mittels frei programmierbarer Positionierungsvorrichtungen über den Leiterplattennutzen positionierbar sind.

10. Anlage zur Fertigung elektronischer Baugruppen und/oder Leiterplatten, welche RFID-Chips oder mit Temperatursensoren ausgestattete oder verbundene RFID-Chips umfassen, **dadurch gekennzeichnet, dass** die RFID-Chips Logistikdaten und/oder prozessspezifische Daten enthalten und die Anlage eine Schreib-/Lesevorrichtung umfasst, mittels der die Logistikdaten und/oder prozessspezifischen Daten lesbar sind und dass die Schreib-/Lesevorrichtung mit einer Prozesssteuervorrichtung verbunden ist, mittels der Fertigungsparameter und/oder Fertigungsschritte und/oder Logistikschritte der Anlage steuerbar sind.

11. Anlage nach Anspruch 10, **dadurch gekennzeichnet, dass** während der Fertigung auftretende Temperaturen, denen die elektronische Baugruppe und/oder Leiterplatte ausgesetzt ist, mittels des Temperatursensors erfassbar und im RFID-Chips speicherbar sind und mittels der Schreib-/Lesevorrichtung nach der Fertigung lesbar sind.

12. Anlage nach Anspruch 10 oder 11, **dadurch gekennzeichnet, dass** mittels der Schreib-/Lesevorrichtung Fertigungs- und/oder Auftragsdaten während oder nach der Fertigung in die RFID-Chips schreibbar sind.

13. Anlage nach einem der Ansprüche 6 bis 12, **dadurch gekennzeichnet, dass** die Schreiblesevorrichtung über eine Schnittstelle oder über eine Schnittstelle und ein Netzwerk mit einer Datenverarbeitungsanlage verbunden ist.
